# EUROPÄISCHE PATENTSCHRIFT

(11) **EP 1 351 550 B1**
(45) Veröffentlichungstag und Bekanntmachung des Hinweises auf die Patenterteilung: **10.11.2010**
(21) Anmeldenummer: 02020202.4
(22) Anmeldetag: 10.09.2002
(51) Int. Cl.: H04R 25/00, H03G 7/00

(54) **Verfahren zur Anpassung einer Signalverstärkung in einem Hörgerät sowie ein Hörgerät**
Method for adapting a signal amplification in a hearing aid and a hearing aid
Procédé d'adaptation d'une amplification de signal dans une prothèse auditive et prothèse auditive

(43) Veröffentlichungstag der Anmeldung: 08.10.2003
(73) Patentinhaber: PHONAK AG, 8712 Stäfa (CH)
(72) Erfinder: Roeck, Hans-Ueli, 8634 Hombrechtikon (CH)
(74) Vertreter: Troesch Scheidegger Werner AG

(56) Entgegenhaltungen:
- WO-A-01/76063
- WO-A-99/34642
- CA-A- 2 090 531
- US-A- 5 903 655
- STONE M A ET AL: "Comparison of different forms of compression using wearable digital hearing aids" JOURNAL OF THE ACOUSTICAL SOCIETY OF AMERICA, DEC. 1999, ACOUST. SOC. AMERICA THROUGH AIP, USA, Bd. 106, Nr. 6, Seiten 3603-3619, XP001162751 ISSN: 0001-4966

## Beschreibung

Die vorliegende Erfindung betrifft ein Verfahren zur Anpassung einer Signalverstärkung in einem Hörgerät, in dem mit Hilfe eines elektro-akustischen Wandlers ein Eingangssignal für eine Signalverarbeitungseinheit erzeugt wird und in dem ein Ausgangssignal über die Signalverstärkung bestimmt wird, sowie ein Hörgerät.

Bekannte Verstärkungsmodelle für Hörgeräte weisen fixe Grenzwerte für Eingangspegel auf, unterhalb derer eine Geräuschsperre (squelch) zum Einsatz kommt. So werden Eingangssignale mit Pegeln, die unterhalb der festgelegten Grenzwerte liegen, grundsätzlich gegenüber Eingangssignalen mit Pegeln, die oberhalb des festgelegten Grenzwertes liegen, reduziert bzw. reduziert verstärkt. Als Vorteil dieser Massnahme ergibt sich, dass Hintergrundgeräusche nicht oder lediglich vermindert verstärkt werden. Als Folge davon wird der Hörgerätträger nicht durch exzessiv verstärkte Hintergrundgeräusche gestört, welche im Wesentlichen ohnehin keine brauchbaren Informationen enthalten.

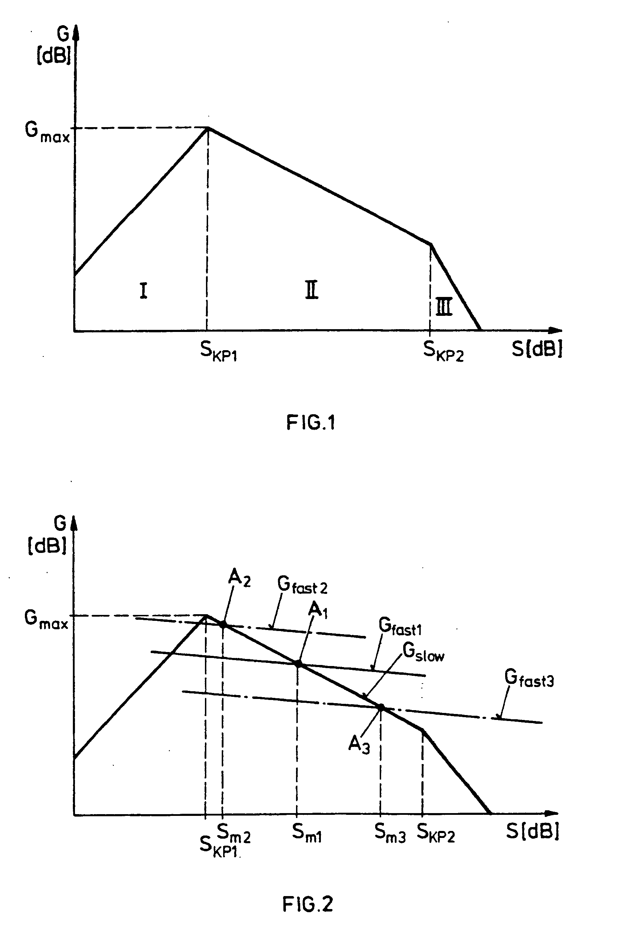

Ein bekannter Verstärkungsverlauf ist in Fig. 1 dargestellt, wobei die Verstärkung G in Funktion des Pegels S des Eingangssignals dargestellt ist. Sowohl die Verstärkung G als auch der Pegel S des Eingangssignals sind in der Einheit Dezibel (dB) angegeben. Aus dem in Fig. 1 dargestellten Verlauf für die Verstärkung G sind drei Bereiche I, II und III identifizierbar, wovon im Bereich I die genannte Geräuschsperre, im Bereich II der normale Betriebsbereich und im Bereich III eine Ausgangspegellimitierung vorgenommen wird. Die Steigung des Verlaufs der Verstärkung G im Bereich II entspricht einer zur Kompensation eines Hörverlustes benötigten Kompression. Demgegenüber wird durch den Verlauf der Verstärkung G im Bereich I vermieden, dass Umgebungsgeräusche, welche üblicherweise keine Informationen für den Hörgerätträger enthalten, entsprechend dem jeweiligen Pegel verstärkt werden. Von Bedeutung ist dabei die Festlegung eines ersten Grenzwertes zwischen den Bereichen I und II, welcher im Folgenden erster Kniepunkt S_{KP1} genannt wird. Wird der Wert des ersten Kniepunktes S_{KP1} zu hoch gewählt, so wird die Verständlichkeit von gesprochenen Worten in sehr leisen Umgebungen herabgesetzt. Wird hingegen der Wert des ersten Kniepunktes S_{KP1} zu tief gewählt, so werden anderseits Störgeräusche zu wenig unterdrückt.

In analoger Weise wird der obere Grenzwert, im Folgenden als zweiter Kniepunkt S_{KP2} bezeichnet, zwischen den Bereichen II und III festgelegt, wobei Eingangssignale mit höherem Pegel als der zweite Kniepunkt S_{KP2} limitiert werden, da man davon ausgeht, dass Eingangssignale mit höheren Werten als der zweite Kniepunkt S_{KP2} im Zusammenhang mit der bei diesem Eingangspegel applizierten Verstärkung, aus der der Ausgangspegel resultiert, für den Hörgerätträger als schmerzend empfunden werden.

Bei fortschrittlicheren Algorithmen, bei denen anstelle des oben erwähnten Einpfad-Systems ein so genanntes Zweipfad-System mit zwei Zeitkonstanten zum Einsatz kommt, sind grundsätzlich die gleichen Nachteil vorhanden. Das bekannte Verfahren basiert auf zwei Zeitkonstanten, nämlich auf einer langen Zeitkonstanten von typischerweise mehreren Sekunden und einer kürzeren Zeitkonstanten von typischerweise mehreren Dutzend Millisekunden. Während über die lange Zeitkonstante die mittlere Verstärkung eingestellt wird, erfolgt über die kürzere Zeitkonstante die eigentliche Silbenkompression. Beide Pfade werden addiert, so dass im Endeffekt der schnelle Pfad, mit den kürzeren Zeitkonstanten, dem langsameren Pfad, der den eigentlichen Arbeitspunkt bestimmt, überlagert ist. Die Verbindung erfolgt dabei über den durch den langsamen Pfad ermittelten Arbeitspunkt.

Ein möglicher Verlauf einer Signalverstärkung für ein solches Zweipfad-System ist in Fig. 2 dargestellt. Auf der Abszisse und der Ordinate sind wiederum die gleichen Grössen in den gleichen Einheiten wie in Fig. 1 eingetragen. Während mit G_{slow} der Verlauf des langsamen Pfades bezeichnet ist, der den eigentlichen Arbeitspunkt A₁, A₂ oder A₃ festlegt, ist mit G_{fast1} bzw. G_{fast2} bzw. G_{fast3} der schnelle Pfad, in dem die Silbenkompression vorgenommen wird, bezeichnet.

Sowohl das Einpfad- als auch das Zweipfad-System weisen erhebliche Probleme auf, wenn sich die Umgebungssituation ändert. So können sich die bekannten Systeme nur schlecht an sich ändernde Umgebungssituationen anpassen.

Ein Einpfad-System kann entweder eine Silbenkompression oder eine automatische Lautstärkenkontrolle (AVC-Automatic Volume Control) vornehmen, nicht jedoch beides. Das bekannte Einpfad-System wurde von Brian C. J. Moore in "Perceptual consequences of cochlear damage" (ISBN 0 19 852330 0, Seiten 179 bis 189) ausführlich beschrieben.

Das Zweipfad-System profitiert ebenfalls von einer reduzierten Verstärkung unterhalb des ersten Kniepunktes S_{KP1}, sofern der Eingangspegel über eine längere Dauer tief ist. Bei kurzen Sprechpausen kann das bekannte Zweipfad-System die Verstärkung daher nicht sinnvoll reduzieren. Wird im schnellen Pfad eines Zweipfad-Systems anderseits auch ein weiterer, fixer Kniepunkt mit reduzierter Verstärkung bei kleineren Eingangspegeln eingeführt, so ist der Kniepunktpegel für sehr leise oder sehr laute Signale jeweils falsch eingestellt, d.h. die Sprachinformation wird nicht mehr genügend verstärkt, oder aber es werden Störgeräusche zu stark verstärkt. Die bekannten Zweipfad-Systeme wurden von Michael Stone et. al. im Aufsatz "Comparison of different forms of compression using waerable digital hearing aids" (J. Acoust. Soc. Am. 106(6), Dezember 1999, Seiten 3603 bis 3609) ausführlich beschrieben.

Der vorliegenden Erfindung liegt daher die Aufgabe zugrunde, ein Verfahren anzugeben, bei dem die vorstehend genannten Nachteile nicht auftreten.

Diese Aufgabe wird durch die in Anspruch 1 angegebenen Massnahmen gelöst. Vorteilhafte Ausgestaltungen der Erfindung sowie ein Hörgerät sind in weiteren Ansprüchen angegeben.

Die Erfindung weist die folgenden Vorteil auf: Indem der minimale Eingangspegel in Abhängigkeit des mittleren Pegels des Eingangssignals adaptiv eingestellt wird, wird den sich ändernden Situationen, die beispielsweise in einer sich ändernden Geräuschkulisse oder einer sich ändernden Lautstärke eines Sprechenden bestehen kann, Rechnung getragen. Als Folge davon werden eine verbesserte Rauschunterdrückung und eine Steigerung des Hörvermögens erreicht.

Das erfindungsgemässe Verfahren hat zur Folge, dass unerwünschte Hintergrundgeräusche wesentlich besser unterdrückt werden als dies bei einem bekannten statischen System der Fall ist. Im Unterschied zu bekannten Geräuschunterdrückungsalgorithmen wird nicht eine Schätzung des lokalen Signal-Rausch-Abstandes (SNR - Signal to Noise) wie beispielsweise bei der spektralen Subtraktion vorgenommen, sondern es wird über eine Evaluation des Langzeit-Verhaltens des Eingangssignalpegels, gegebenenfalls in gewissen Frequenzbändern, eine Geräuschunterdrückung realisiert. Dabei wird die Tatsache ausgenutzt, dass Sprachsignale einen definierten dynamischen Bereich um einen mittleren Pegel aufweisen. Signalpegel, welche über bzw. unter dem besagten Bereich liegen können als Störsignale betrachtet und demzufolge ohne weiteres eliminiert werden.

Die Erfindung wird nachfolgend anhand von Zeichnungen beispielsweise näher erläutert. Dabei zeigen:
- Fig. 1: einen bekannten, stückweise linearen Verstärkungsverlauf bei einem Einpfad-System,
- Fig. 2: einen bekannten Verstärkungsverlauf bei einem Zweipfad-System, bestehend aus einem langsamen und einem schnellen Pfad,
- Fig. 3: ein Blockschaltbild eines Hörgerätes und
- Fig. 4: einen erfindungsgemässen Verstärkungsverlauf bei einem Zweipfad-System.

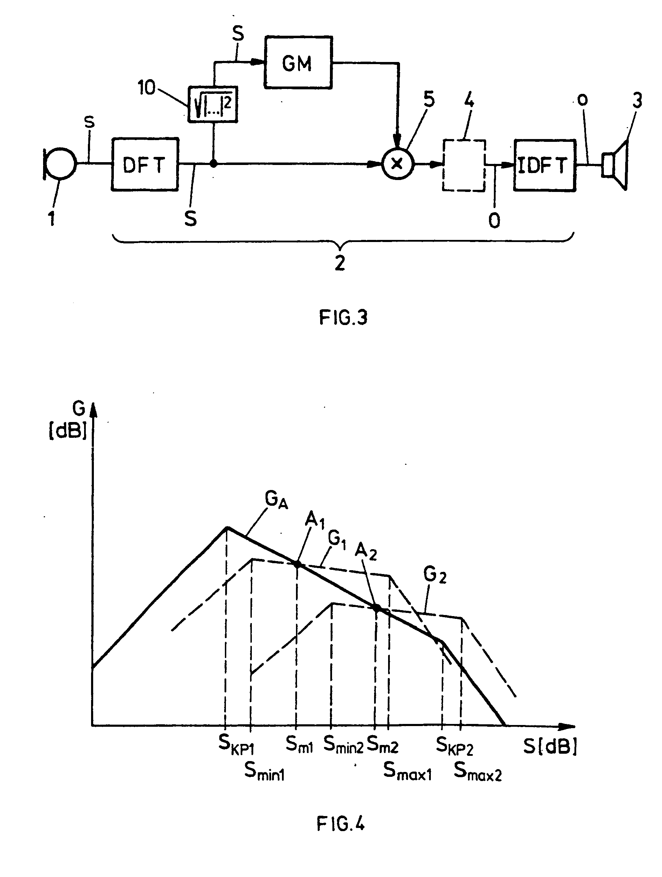

In Fig. 3 ist ein Blockschaltbild eines Hörgerätes dargestellt, das aus einem elektro-akustischen Wandler 1, mit Hilfe dessen akustische Signale in elektrische Signale, nachstehend als Eingangssignal s bezeichnet, konvertiert werden, einer Signalverarbeitungseinheit 2, der das Eingangssignal s beaufschlagt ist, sowie einer Lautsprechereinheit 3, welche in der Hörgerätbranche auch etwa als Hörer bezeichnet wird, besteht.

Die eingangs beschriebenen Einpfad- und Zweipfad-Systeme werden einerseits in Hörgeräten eingesetzt, die zur Korrektur eines Hörschadens bei einem Patienten verwendet werden. Anderseits kommen die beschriebenen Systeme auch in Hörhilfegeräten zum Einsatz, um das Hören in speziellen Situationen zu verbessern, so beispielsweise bei Abhörvorgängen. Im folgenden werden daher unter dem Begriff "Hörgerät" alle möglichen Anwendungen im Zusammenhang mit einem besseren Hören verstanden, und zwar unabhängig davon, ob die dabei verwendeten Vorrichtungen teilweise oder vollständig in den Gehörgang eingesetzt werden - wie dies bei so genannten BtE-(Behind-the-Ear)- oder CIC-(Completely-in-the-Canal)-Hörgeräten der Fall ist - oder ob die verwendeten Vorrichtungen sogar in den menschlichen Körper implantiert werden bzw. sind.

In der Signalverarbeitungseinheit 2 gemäss Fig. 3 werden die Signale vorzugsweise in digitaler Form verarbeitet, so dass zusätzlich zu den dargestellten Verarbeitungseinheiten Analog/Digital-Wandler bzw. Digital/Analog-Wandler vorzusehen sind. Des Weiteren erfolgt die Verarbeitung der Signale bei der in Fig. 3 dargestellten Ausführungsform im Frequenzbereich. Eine analoge Ausführungsform ergibt sich bei einer Ausführungsvariante, bei der die Signale im Zeitbereich verarbeitet werden. Die Überführung der in Fig. 3 dargestellten Ausführungsvarianten in eine Form, in der alle Signale im Zeitbereich vorhanden sind und in diesem verarbeitet werden, lässt sich durch einen Fachmann mit Kenntnissen in der Signalverarbeitung in einfacher Weise realisieren.

Bei einer Verarbeitung im Frequenzbereich wird - wie dies aus Fig. 3 hervorgeht - das Eingangssignal s einer Transformationseinheit DFT beaufschlagt, in welcher der Pegel S in Funktion der Frequenz bestimmt wird. In der Transformationseinheit DFT kommt vorzugsweise die so genannte Fast Fourier-Transformation zum Einsatz. Selbstverständlich können auch andere Transformationsalgorithmen oder auch Filterbänke eingesetzt werden. In der Folge wird das Eingangssignal s sowohl einem ersten Eingang einer Multiplikatoreinheit 5 als auch einer Berechnungseinheit 10, in der der Signalpegel S beispielsweise als RMS-(Root Mean Square)-Pegel bestimmt wird, beaufschlagt. Das Ausgangssignal der Berechnungseinheit 10 wird einer Verstärkungseinheit GM und deren Ausgangssignal einem zweiten Eingang der Multiplikatoreinheit 5 beaufschlagt, so dass das Ausgangssignal der Multiplikatoreinheit 5, d.h. der Pegel O des Ausgangssignals, durch ein in der Verstärkereinheit GM implementiertes Verstärkermodell beeinflusst wird, was im folgenden im Detail erläutert werden wird. Bevor in einer Rücktransformationseinheit IDFT wiederum in den Zeitbereich übergegangen wird, ist denkbar, dass weitere Verarbeitungsschritte in Operationseinheiten 4 angewendet werden. Ein solcher weiterer Verarbeitungsschritt kann beispielsweise ein Limitieren des Pegels des Ausgangssignals auf einen maximalen Wert beinhalten.

Schliesslich wird das Ausgangssignal o der Rücktransformationseinheit IDFT der Lautsprechereinheit 3 beaufschlagt, in der ein entsprechendes akustisches Signal erzeugt wird. Bei nicht-implantierbaren Hörgeräten wird dieses akustische Signal in den Gehörgang des Hörgerätträgers geleitet. Bei implantierbaren Hörgeräten kann die Lautsprechereinheit 3 wegfallen. Die akustische Stimulation wird dann in anderer Weise vorgenommen, nämlich indem das Ausgangssignal o in ein anderes, vom menschlichen Körper wahrnehmbares Signal transformiert wird.

Anhand von Fig. 4 wird nun das erfindungsgemässe Verfahren erläutert, das im wesentlichen in der Verstärkereinheit GM implementiert ist, wobei den Erläuterungen ein Zweipfad-System zugrunde gelegt wird.

Fig. 4 zeigt mit durchgezogener Linie einen Verstärkungsverlauf eines langsamen Pfades in Funktion des Pegels S des Eingangssignals s. Wie beim bekannten System, das anhand von Fig. 2 erläutert worden ist, wird der mittlere Pegel Sₘ des Eingangssignals s mit einer Zeitkonstanten von einigen Sekunden bestimmt. Ein momentaner mittlerer Wert für den Pegel Sₘ des Eingangssignals s legt dabei einen momentanen Arbeitspunkt fest, wie dies beispielsweise mit zwei unterschiedlichen Arbeitspunkten A₁ und A₂ in Fig. 4 illustriert ist. Im momentanen Arbeitspunkt A₁ bzw. A₂ wird dann über einen zweiten, schnellen Pfad eine spezifische Silbenkompression wirksam, wie dies mit den strichliniert dargestellten Verstärkungsverläufen G₁ und G₂ angedeutet ist. Im Unterschied zum bekannten, anhand von Fig. 1 und 2 erläuterten Verfahren wird nun erfindungsgemäss der Verstärkungsverlauf bezüglich des schnellen Pfades derart laufend adaptiert, indem unterhalb eines minimalen Eingangssignalpegels Sₘᵢₙ₁ bzw. Sₘᵢₙ₂, der um einen vorgebbaren ersten Differenzwert Δₘᵢₙ unterhalb des momentanen mittleren Pegels Sₘ₁ bzw. Sₘ₂ des Eingangssignals s liegt, eine Geräuschsperre appliziert wird. Im Allgemeinen wird der Verstärkungsverlauf für tiefere Eingangssignalpegel S als der minimale Eingangssignalpegel Sₘᵢₙ₁ bzw. Sₘᵢₙ₂ einen anderen Verlauf haben als für höhere Eingangssignalpegel S als der minimale Eingangssignalpegel Sₘᵢₙ₁ bzw. Sₘᵢₙ₂. Gemäss den in Fig. 4 dargestellten Verstärkungsverläufen G₁ und G₂ für die Silbenkompression, d.h. im schnellen Pfad, fallen die Verstärkungsverläufe G₁ und G₂ unterhalb des minimalen Eingangssignalpegels Sₘᵢₙ₁ bzw. Sₘᵢₙ₂ vorzugsweise linear ab, mit anderen Worten werden Signalpegel, die sich weiter unterhalb des minimalen Eingangspegels Sₘᵢₙ₁ bzw. Sₘᵢₙ₂ als andere befinden, weniger verstärkt. Dabei knüpfen die Verstärkungsverläufe G₁ und G₂, vorzugsweise ohne Diskontinuität, an die entsprechenden Verläufe in den Kompressionsbereichen an. Die Silbenkompression weist über den gesamten Pegelbereich des Eingangssignals s in einer Ausführungsform der Erfindung einen stückweise linearen Verlauf auf.

In einer weiteren Ausführungsform der Erfindung ist darüber hinaus vorgesehen, dass für jeden Verstärkungsverlauf G₁ bzw. G₂ ein maximaler Eingangssignalpegel Sₘₐₓ₁ bzw. Sₘₐₓ₂ bestimmt wird, oberhalb dessen eine Signallimitierung vorgesehen ist. Der maximale Eingangssignalpegel Sₘₐₓ₁ bzw. Sₘₐₓ₂ liegt dabei um einen vorgebbaren Differenzwert Δₘₐₓ oberhalb des momentanen mittleren Pegels Sₘ₁ bzw. Sₘ₂ des Eingangssignals s. Im Allgemeinen wird der Verstärkungsverlauf für höhere Eingangssignalpegel S als der maximale Eingangssignalpegel Sₘₐₓ₁ bzw. Sₘₐₓ₂ einen anderen Verlauf haben als für tiefere Eingangssignalpegel S als der maximale Eingangssignalpegel Sₘₐₓ₁ bzw. Sₘₐₓ₂. Gemäss den in Fig. 4 dargestellten Verstärkungsverläufen G₁ und G₂ für die Silbenkompression, d.h. im schnellen Pfad, fallen die Verstärkungsverläufe G₁ und G₂ oberhalb des maximalen Eingangssignalpegels Sₘₐₓ₁ bzw. Sₘₐₓ₂ beispielsweise linear ab, mit anderen Worten werden Signalpegel, die sich weiter oberhalb des maximalen Eingangspegels Sₘₐₓ₁ bzw. Sₘₐₓ₂ als andere befinden, weniger verstärkt. Dabei knüpfen die Verstärkungsverläufe G₁ und G₂, vorzugsweise ohne Diskontinuität, an die entsprechenden Verläufe in den Kompressionsbereichen an. Die Silbenkompression weist über den gesamten Pegelbereich des Eingangssignals s in einer Ausführungsform einen stückweise linearen Verlauf auf.

Es wird darauf hingewiesen, dass zum Thema Signallimitierung von der gleichen Anmelderin eine internationale Patentanmeldung mit der Veröffentlichungsnummer WO 01/76 063 A3 besteht. Das darin beschriebene Verfahren eignet sich vorzüglich in Kombination mit der beschriebenen adaptiven Geräuschsperre.

Zur Festlegung der minimalen und maximalen Eingangssignalpegel Sₘᵢₙ₁ und Sₘₐₓ₁ bzw. Sₘᵢₙ₂ und Sₘₐₓ₂ wird dem Umstand Rechnung getragen, dass die menschliche Sprache einen Dynamikbereich von ca. -15 bis +18dB (Dezibel) um den jeweiligen mittleren Pegel Sₘ aufweist, wobei in ruhiger Umgebung, d.h. bei geringen Umgebungsgeräuschen, der mittlere Pegel ca. 60 bis 65 dB beträgt. Bei lauter Umgebung kann der mittlere Pegel auf ca. 80 dB ansteigen. Ausgehend von diesen Gegebenheiten wird der erste vorgebbare Differenzwert Δₘᵢₙ vorzugsweise gleich 15 dB und der zweite vorgebbare Differenzwert Δₘₐₓ vorzugsweise gleich 18 dB gewählt.

Die vorstehenden Ausführungen im Zusammenhang mit Fig. 4 beziehen sich auf ein Zweipfad-System, bei dem die minimalen, gegebenenfalls zusätzlich auch die maximalen Pegel Sm des Eingangssignals s adaptiv eingestellt werden. In analoger Weise ist die Erfindung auf ein Einpfad-System übertragbar, bei dem der einzige Kniepunkt, d.h. der einzige minimale Eingangssignalpegel, adaptiv in Abhängigkeit vom mittleren Pegel des Eingangssignals eingestellt wird.

Unabhängig von den vorstehend erläuterten Ausführungsvarianten kann die Schätzung des mittleren Pegels entweder in einem breiten Frequenzband vorgenommen werden oder aber es können mehrere Frequenzbänder definiert werden, wobei es dann denkbar ist, dass in jedem der Frequenzbänder individuelle Kniepunkte, d.h. minimale und gegebenenfalls maximale Eingangssignalpegel, unter Anwendung einer individuellen lokalen Statistik bestimmt werden.

Es wird ausdrücklich darauf hingewiesen, dass, wenn immer der Ausdruck "mittlerer Pegel" in der vorliegenden Beschreibung verwendet wird, irgendein Referenzpegel darunter zu verstehen ist, der mit Hilfe einer beliebigen Statistik berechnet werden kann.

Denkbar ist auch, und zwar wiederum in Kombination mit allen vorstehend beschriebenen Ausführungsvarianten der Erfindung, dass der Verstärkungsverlauf unterhalb der minimalen Eingangssignalpegel des langsamen Pfades unterschiedlich gewählt wird verglichen mit dem Verstärkungsverlauf des schnellen Pfades. So ist denkbar, dass im einen Pfad ein linearer Verstärkungsverlauf und im anderen ein kompressiver bzw. ein expansiver Verstärkungsverlauf vorgesehen wird.

## Patentansprüche

1. Verfahren zur Anpassung einer Signalverstärkung (G) in einem Hörgerät, in dem mit Hilfe eines elektro-akustischen Wandlers (1) ein Eingangssignal (s) für eine Signalverarbeitungseinheit (2) erzeugt wird und in dem ein Ausgangssignal (o) über die Signalverstärkung (G) bestimmt wird, wobei das Verfahren darin besteht,
- dass ein Referenzpegel (Sₘ; Sₘ₁, Sₘ₂) des Eingangssignals (s) unter Anwendung von statistischen Berechnungsmethoden bestimmt wird,
- dass ein minimaler Eingangssignalpegel (Sₘᵢₙ; Sₘᵢₙ₁, Sₘᵢₙ₂) bestimmt wird, indem vom Referenzpegel (Sₘ; Sₘ₁, Sₘ₂) des Eingangssignals (s) ein vorgebbarer Differenzwert (Δₘᵢₙ) subtrahiert wird, und
- dass auf Eingangssignale (s) mit einem Signalpegel, der unterhalb des minimalen Eingangssignalpegels (Sₘᵢₙ; Sₘᵢₙ₁, Sₘᵢₙ₂) liegt, ein Verstärkungsverlauf bzw. eine Verstärkungsfunktion appliziert wird, die sich von einer oberhalb des minimalen Eingangssignalpegels (Sₘᵢₙ; Sₘᵢₙ₁, Sₘᵢₙ₂) unterscheidet.

2. Verfahren nach Anspruch 1, **dadurch gekennzeichnet, dass** auf Eingangssignale (s) mit einem Signalpegel, der unterhalb des minimalen Eingangssignalpegels (Sₘᵢₙ; Sₘᵢₙ₁, Sₘᵢₙ₂) liegt, eine Geräuschsperre bzw. eine Geräuschunterdrückung appliziert wird.

3. Verfahren nach Anspruch 1 oder 2, **dadurch gekennzeichnet, dass** für die Signalverstärkung (G) im Bereich des minimalen Eingangssignalpegels (Sₘᵢₙ; Sₘᵢₙ₁, Sₘᵢₙ₂) ein stetiger Verlauf vorgesehen ist.

4. Verfahren nach Anspruch 1 oder 2, **dadurch gekennzeichnet, dass** für die Signalverstärkung (G) im Bereich des minimalen Eingangssignalpegels (Sₘᵢₙ; Sₘᵢₙ₁, Sₘᵢₙ₂) ein zusammenhängender Verlauf vorgesehen ist.

5. Verfahren nach einem der Ansprüche 1 bis 4, **dadurch gekennzeichnet,**
- **dass** ein maximaler Eingangssignalpegel (Sₘₐₓ; Sₘₐₓ₁, Sₘₐₓ₂) bestimmt wird, indem zum Referenzpegel (Sₘ; Sₘ₁, Sₘ₂) des Eingangssignals (s) ein vorgebbarer zweiter Differenzwert (Δₘₐₓ) addiert wird, und
- **dass** auf Eingangssignale (s) mit einem Signalpegel, der oberhalb des maximalen Eingangssignalpegels (Sₘₐₓ; Sₘₐₓ₁, Sₘₐₓ₂) liegt, eine Signallimitierung appliziert wird.

6. Verfahren nach einem der Ansprüche 1 bis 5, **dadurch gekennzeichnet, dass** der Frequenzbereich des gesunden menschlichen Gehörs in mindestens zwei Frequenzbänder aufgeteilt wird und dass in jedem dieser Frequenzbänder ein Referenzpegel (Sₘ; Sₘ₁, Sₘ₂) des Eingangssignals (s) bestimmt wird.

7. Verfahren nach einem der Ansprüche 4 bis 6, **dadurch gekennzeichnet, dass** die Differenzwerte (Aₘᵢₙ, Aₘₐₓ) derart gewählt werden, dass der gesamte Dynamikbereich von Sprachsignalen abgedeckt ist.

8. Verfahren nach einem der Ansprüche 1 bis 7, **dadurch gekennzeichnet,**
- **dass** der Referenzpegel (Sₘ₁, Sₘ₂) des Eingangssignals (s) zur Bestimmung eines Arbeitspunktes (A₁, A₂) auf einem vorgebbaren Signalverstärkungsverlauf (G_{A}) verwendet wird, wobei zur Bestimmung des Referenzpegels (Sₘ₁, Sₘ₂) eine erste Zeitkonstante verwendet wird, und
- **dass** dem vorgebbaren Signalverstärkungsverlauf (G_{A}) im bestimmten Arbeitspunkt (A₁, A₂) ein Signalverstärkungsverlauf (G₁, G₂) überlagert wird, dem, basierend auf einer zweiten Zeitkonstante, gefolgt wird,
wobei die erste Zeitkonstante grösser ist als die zweite Zeitkonstante.

9. Verfahren nach einem der vorangehenden Ansprüche, **dadurch gekennzeichnet, dass** als Referenzpegel (Sₘ; Sₘ₁, Sₘ₂) ein momentaner Mittelwert des Eingangssignalpegels (s) verwendet wird.

10. Hörgerät mit einem elektro-akustischen Wandler (1) zur Erzeugung eines Eingangssignals (s), das einer Signalverarbeitungseinheit (2) beaufschlagt ist, in der ein Ausgangssignal (o) erzeugbar ist, **dadurch gekennzeichnet, dass** in der Signalverarbeitungseinheit (2):
- ein Referenzpegel (Sₘ; Sₘ₁, Sₘ₂) des Eingangssignals (s) bestimmbar ist,
- ein minimaler Eingangsignalpegel (Sₘᵢₙ; Sₘᵢₙ₁, Sₘᵢₙ₂) bestimmbar ist, indem vom Referenzpegel (Sₘ; Sₘᵢₙ₁, Sₘᵢₙ₂) des Eingangssignals (s) ein vorgebbarer Differenzwert (Δₘᵢₙ) subtrahierbar ist, und
- eine Verstärkungsfunktion, die sich von einer oberhalb des minimalen Eingangssignalpegels (Sₘᵢₙ; Sₘᵢₙ₁, Sₘᵢₙ₂) vorhandenen Verstärkungsfunktion unterscheidet, auf Eingangssignale (s) mit einem Pegel applizierbar ist, die unterhalb des minimalen Eingangssignalpegels (Sₘᵢₙ; Sₘᵢₙ₁, Sₘᵢₙ₂) liegen.

11. Hörgerät nach Anspruch 10, **dadurch gekennzeichnet, dass** auf Eingangssignale (s) mit einem Signalpegel, der unterhalb des minimalen Eingangssignalpegels (Sₘᵢₙ; Sₘᵢₙ₁, Sₘᵢₙ₂) liegt, eine Geräuschsperre bzw. eine Geräuschunterdrückung applizierbar ist.

12. Hörgerät nach Anspruch 10 oder 11, **dadurch gekennzeichnet, dass** die Signalverstärkung (G) im Bereich des minimalen Eingangssignalpegels (Sₘᵢₙ; Sₘᵢₙ₁, Sₘᵢₙ₂) ein stetiger Verlauf aufweist.

13. Hörgerät nach Anspruch 10 oder 11, **dadurch gekennzeichnet, dass** die Signalverstärkung (G) im Bereich des minimalen Eingangssignalpegels (Sₘᵢₙ; Sₘᵢₙ₁, Sₘᵢₙ₂) ein zusammenhängender Verlauf aufweist.

14. Hörgerät nach einem der Ansprüche 10 bis 13, **dadurch gekennzeichnet,**
- **dass** ein maximaler Eingangssignalpegel (Sₘₐₓ; Sₘₐₓ₁, Sₘₐₓ₂) bestimmbar ist, indem zum Referenzpegel (Sₘ; Sₘ₁, Sₘ₂) des Eingangssignals (s) ein vorgebbarer zweiter Differenzwert (Δₘₐₓ) addierbar ist, und
- **dass** auf Eingangssignale (s) mit einem Signalpegel, der oberhalb des maximalen Eingangssignalpegels (Sₘₐₓ; Sₘₐₓ₁, Sₘₐₓ₂) liegt, eine Signallimitierung applizierbar ist.

15. Hörgerät nach einem der Ansprüche 10 bis 14, **dadurch gekennzeichnet, dass** der Frequenzbereich des gesunden menschlichen Gehörs in mindestens zwei Frequenzbänder aufteilbar ist und dass in jedem dieser Frequenzbänder ein Referenzpegel (Sₘ; Sₘ₁, Sₘ₂) des Eingangssignals (s) bestimmbar ist.

16. Hörgerät nach einem der Ansprüche 14 bis 15, **dadurch gekennzeichnet, dass** die Differenzwerte (Δₘᵢₙ, Δₘₐₓ) derart gewählt werden, dass der gesamte Dynamikbereich von Sprachsignalen abgedeckt ist.

17. Hörgerät nach einem der Ansprüche 10 bis 16, **dadurch gekennzeichnet,**
- **dass** der Referenzpegel (Sₘ₁, Sₘ₂) des Eingangssignals (s) zur Bestimmung eines Arbeitspunktes (A₁, A₂) auf einem vorgebbaren Signalverstärkungsverlauf (G_{A}) verwendbar ist, wobei zur Bestimmung des Referenzpegels (Sₘ₁, Sₘ₂) eine erste Zeitkonstante vorgesehen ist, und
- **dass** dem vorgebbaren Signalverstärkungsverlauf (G_{A}) im bestimmten Arbeitspunkt (A₁, A₂) ein Signalverstärkungsverlauf (G₁, G₂) überlagerbar ist, dem, basierend auf einer zweiten Zeitkonstante, gefolgt wird,
wobei die erste Zeitkonstante grösser ist als die zweite Zeitkonstante.

18. Hörgerät nach einem der Ansprüche 10 bis 17, **dadurch gekennzeichnet, dass** als Referenzpegel (Sₘ; Sₘ₁, Sₘ₂) ein momentaner Mittelwert des Eingangssignalpegels (s) verwendbar ist.

## Claims

1. Method for adapting a signal amplification (G) in a hearing device, in which an input signal (s) is generated for a signal processing unit (2) with the aid of an electro-acoustic converter (1), and in which hearing device an output signal (o) is generated by applying the signal amplification (G), the method comprising the steps of:
- determining a reference level (Sₘ; Sₘ₁, Sₘ₂) of the input signal (s) by using statistical calculation methods,
- determining a minimum input signal level (Sₘᵢₙ; Sₘᵢₙ₁, Sₘᵢₙ₂) by subtracting a predefined difference value (Δₘᵢₙ) from the reference level (Sₘ; Sₘ₁, Sₘ₂) of the input signal (s), and
- applying an amplification function to input signals (s) with a signal level which lies below the minimum input signal level (Sₘᵢₙ; Sₘᵢₙ₁, Sₘᵢₙ₂), the amplification function being different from the one applied above the minimum input signal level (Sₘᵢₙ; Sₘᵢₙ₁, Sₘᵢₙ₂).

2. Method according to claim 1, **characterised in that** a squelch or a noise suppression is applied to input signals (s) with a signal level which lies below the minimum input signal level (Sₘᵢₙ; Sₘᵢₙ₁, Sₘᵢₙ₂).

3. Method according to claim 1 or 2, **characterised in that** a steady course is provided for the signal amplification (G) in the region of the minimum input signal level (Sₘᵢₙ; Sₘᵢₙ₁, Sₘᵢₙ₂).

4. Method according to claim 1 or 2, **characterised in that** a continuous course is provided for the signal amplification (G) in the region of the minimum input signal level (Sₘᵢₙ; Sₘᵢₙ₁, Sₘᵢₙ₂).

5. Method according to one of the claims 1 to 4, **characterised in** further comprising the steps of:
- determining a maximum input signal level (Sₘₐₓ; Sₘₐₓ₁, Sₘₐₓ₂) by adding a predetermined second difference value (Δₘₐₓ) to the reference level (Sₘ; Sₘ₁, Sₘ₂) of the input signal (s), and
- applying a signal limiting to input signals (s) with a signal level which lies above the maximum input signal level (Sₘₐₓ; Sₘₐₓ₁, Sₘₐₓ₂).

6. Method according to one of the claims 1 to 5, **characterised in that** the frequency range of the healthy human hearing is divided into at least two frequency bands and that in each of the frequency bands a reference level (Sₘ; Sₘ₁, Sₘ₂) of the input signal (s) is determined.

7. Method according to one of the claims 4 to 6, **characterised in that** the difference values (Aₘᵢₙ, Δₘₐₓ) are chosen in such a manner that the whole dynamic range of speech signals is covered.

8. Method according to one of the claims 1 to 7, **characterised in** further comprising the steps of:
- using the reference level (Sₘ₁, Sₘ₂) of the input signal (s) to determine an operating point (A₁, A₂) of a give signal amplification course (G_{A}), a first time constant being used to determine the reference level (Sₘ₁, Sₘ₂), and
- superimposing on the predetermined signal amplification course (G_{A}) in the determined operating point (A₁, A₂) a signal amplification course (G₁, G₂), which is followed based on a second time constant,
the first time constant being greater than the second time constant.

9. Method according to one of the preceding claims, **characterised in that** a momentary mean value of the input signal level is used as reference level (Sₘ; Sₘ₁, Sₘ₂).

10. Hearing device with an electro-acoustic converter (1) for generating an input signal (s), which is fed to a signal processing unit (2), in which an output signal (o) is generatable, **characterised in that** in the signal processing unit (2):
- a reference level (Sₘ; Sₘ₁, Sₘ₂) of the input signal (s) is determinable,
- a minimum input signal level (Sₘᵢₙ; Sₘᵢₙ₁, Sₘᵢₙ₂) is determinable by subtracting a given difference value (Δₘᵢₙ) from the reference level (Sₘ; Sₘ₁, Sₘ₂) of the input signal (s), and
- an amplification function, which differs from one being provided above the minimum input signal level (Sₘᵢₙ; Sₘᵢₙ₁, Sₘᵢₙ₂), is applicable to input signals (s) with a level which lies below the minimum input signal level (Sₘᵢₙ; Sₘᵢₙ₁, Sₘᵢₙ₂).

11. Hearing device according to claim 10, **characterised in that** a squelch or a noise suppression is applicable to input signals (s) with a signal level which lies below the minimum input signal level (Sₘᵢₙ; Sₘᵢₙ₁, Sₘᵢₙ₂).

12. Hearing device according to claim 10 or 11, **characterised in that** the signal amplification (G) has a steady course in the region of the minimum input signal level (Sₘᵢₙ; Sₘᵢₙ₁, Sₘᵢₙ₂).

13. Hearing device according to claim 10 or 11, **characterised in that** the signal amplification (G) has a continuous course in the region of the minimum input signal level (Sₘᵢₙ; Sₘᵢₙ₁, Sₘᵢₙ₂).

14. Hearing device according to one of the claims 10 to 13, **characterised in that**:
- a maximum input signal level (Sₘₐₓ; Sₘₐₓ₁, Sₘₐₓ₂) is determinable by adding a predefined second difference value (Δₘₐₓ) to the reference level (Sₘ; Sₘ₁, Sₘ₂) of the input signal (s), and
- a signal limiting is applicable to input signals (s) with a signal level that lies above the maximum input signal level (Sₘₐₓ; Sₘₐₓ₁, Sₘₐₓ₂).

15. Hearing device according to one of the claims 10 to 14, **characterised in that** the frequency range of the healthy human hearing is dividable into at least two frequency bands, and that in each of the frequency bands a reference level (Sₘ; Sₘ₁, Sₘ₂) of the input signal (s) is determinable.

16. Hearing device according to one of the claims 14 to 15, **characterised in that** the difference values (Δₘᵢₙ, Aₘₐₓ) are chosen to be such that the whole dynamic range of speech signals is covered.

17. Hearing device according to one of the claims 10 to 16, **characterised in that**:
- the reference level (Sₘ₁, Sₘ₂) of the input signal (s) is usable to determine the operating point (A₁, A₂) on a given signal amplification course (G_{A}), a first time constant being provided to determined the reference level (Sₘ₁, Sₘ₂), and
- a signal amplification course (G₁, G₂) is superimposable on the given signal amplification course (G_{A}) in the determined operating point (A₁, A₂), the signal amplification course being followed by a second time constant,
the first time constant being greater than the second time constant.

18. Hearing device according to one of the claims 10 to 17, **characterised in that** a momentary mean value of the input signal level is usable as reference level (Sₘ; Sₘ₁, Sₘ₂) .

## Revendications

1. Procédé pour ajustement un gain de signal (G) dans un appareil auditif, dans lequel un signal d'entrée (s) pour une unité de traitement de signal (2) est généré à l'aide d'un transducteur électro-acoustique (1) et dans lequel un signal d'exit (o) est déterminé par le gain de signal (G), le procédé comportant,
- qu'un niveau de référence (Sm; Sm1; sm2) du signal d'entrée (s) est déterminé en appliquant des méthodes de calcul statistiques,
- qu'un niveau de signal d'entrée minimal (Smin; Smin1; Smin2) est déterminé en soustrayant une valeur de différence déterminable (Δmin) du niveau de référence (Sm; Sm1; sm2) du signal d'entrée (s), et
- qu'un déroulement de gain ou une fonction de gain, respectivement, qui se diffère d'un déroulement de gain ou d'une fonction de gain au-dessus du niveau de signal d'entrée minimal (Smin; Smin1; Smin2), est appliqué sur des signaux d'entrée (s) avec un niveau de signal étant au-dessous du niveau de signal d'entrée minimal (Smin; Smin1; Smin2).

2. Procédé selon la revendication 1, **caractérisé en ce qu'**un blocage de bruit ou une suppression de bruit, respectivement, est appliqué sur les signaux d'entrée (s) avec un niveau de signal étant au-dessous du niveau de signal d'entrée minimal (Smin; Smin1; Smin2).

3. Procédé selon la revendication 1 ou 2, **caractérisé en ce qu'**un déroulement continu est prévu pour le gain de signal (G) dans le domaine du niveau de signal d'entrée minimal (Smin; Smin1; Smin2).

4. Procédé selon la revendication 1 ou 2, **caractérisé en ce qu'**un déroulement cohérent est prévu pour le gain de signal (G) dans le domaine du niveau de signal d'entrée minimal (Smin; Smin1; Smin2).

5. Procédé selon une des revendications 1 à 4, **caractérisé en ce qu'**
- un niveau de signal d'entrée maximal (Smax; Smax1; Smax2) est déterminé en additionnant une deuxième valeur de différence (Δmax) déterminable au niveau de référence (Sm; Sm1; Sm2) du signal d'entrée (s), et
- une limitation de signal est appliquée sur les signaux d'entrée (s) avec un niveau de signal étant au-dessus du niveau de signal d'entrée maximal (Smax; Smax1; Smax2).

6. Procédé selon une des revendications 1 à 5, **caractérisé en ce que** le domaine de fréquence de l'ouïe humaine saine est divisé en au moins deux bandes de fréquence et qu'un niveau de référence (Sm; Sm1; Sm2) du signal d'entrée (s) est déterminé en chaque de ces bandes de fréquence.

7. Procédé selon une des revendications 4 à 6, **caractérisé en ce que** les valeurs de différence (Δmin, Δmax) sont choisies telles que le domaine dynamique entier est couvert par des signaux de parole.

8. Procédé selon une des revendications 1 à 7, **caractérisé en ce qu'**
- un niveau de référence (Sm1; Sm2) du signal d'entrée (s) pour la détermination d'un point de travail (A1, A2) est utilisé sur un déroulement de gain de signal (GA) en utilisant une première constante de temps pour la détermination du niveau de référence (Sm1; Sm2), et
- un déroulement de gain de signal (G1, G2) est superposé au déroulement de gain de signal déterminable (GA) dans le point de travail (A1, A2), qui est suivi, basant sur une deuxième constante de temps,
la première constante de temps étant plus grande que la deuxième constante de temps.

9. Procédé selon une des revendications précédentes, **caractérisé en ce qu'**une valeur moyenne momentanée du niveau de signal d'entrée (s) est utilisée comme niveau de référence (Sm; Sm1; Sm2).

10. Appareil auditif avec un transducteur électro-acoustique (1) pour générer un signal d'entrée (s) étant superposé à une unité de traitement de signal (2) dans laquelle un signal d'exit (o) est générable, **caractérisé en ce que** dans l'unité de traitement de signal (2):
- un niveau de référence (Sm; Sm1; Sm2) du signal d'entrée est déterminable,
- en soustrayant une valeur de différence déterminable (Δmin) du niveau de référence (Sm; Sm1; sm2) du signal d'entrée (s), et
- qu' une fonction de gain, qui se diffère d'une fonction de gain existante au-dessus du niveau de signal d'entrée minimal (Smin; Smin1; Smin2), est appliqué sur des signaux d'entrée (s) avec un niveau de signal qui sont au-dessous du signal d'entrée minimal (Smin; Smin1; Smin2).

11. Appareil auditif selon la revendication 10, **caractérisé en ce que** un blocage de bruit ou une suppression de bruit, respectivement, est applicable sur les signaux d'entrée (s) avec un niveau de signal qui est au-dessous du niveau de signal d'entrée minimal (Smin; Smin1; Smin2).

12. Appareil auditif selon la revendication 10 ou 11, **caractérisé en ce que** le gain de signal (G) comporte un déroulement continu dans le domaine du niveau de signal d'entrée minimal (Smin; Smin1; Smin2).

13. Appareil auditif selon la revendication 10 ou 11, **caractérisé en ce que** le gain de signal (G) comporte un déroulement cohérent dans le domaine du niveau de signal d'entrée minimal (Smin; Smin1; Smin2).

14. Appareil auditif selon une des revendications 10 à 13, **caractérisé en ce qu'**
- qu'un niveau de signal d'entrée maximal (Smax; Smax1; Smax2) est déterminable en additionnant une deuxième valeur déterminable (Δmax) au niveau de référence (Sm; Sm1; Sm2), et
- qu'une limitation de signal est applicable sur les signaux d'entrée (s) avec un niveau de signal qui est au-dessus du niveau de signal d'entrée maximal (Smax; Smax1; Smax2).

15. Appareil auditif selon une des revendications 10 à 14, **caractérisé en ce que** le domaine de fréquence de l'ouïe humaine saine est divisible en au moins deux bandes de fréquence et qu'un niveau de référence (sm, sm1, sm2) du signal d'entrée (s) est déterminable dans chaque de ces bandes de fréquence.

16. Appareil auditif selon une des revendications 14 à 15, **caractérisé en ce que** les valeurs de différence (Δmin, Δmax) sont choisies telles que le domaine dynamique entier est couvert par des signaux de parole.

17. Appareil auditif selon une des revendications 10 à 16, **caractérisé en ce que**
- le niveau de référence (sm1, sm2) du signal d'entrée (s) est utilisable pour la détermination d'un point de travail (A1, A2) sur un déroulement de gain de signal (GA) une première constante de temps étant prévue pour la détermination du niveau de référence (sm1, sm2), et
- un déroulement de gain de signal (G1, G2) est superposable au déroulement de signal déterminable (GA) dans le point de travail (A1, A2) déterminé, qui est suivi basant sur une deuxième constante de temps,
la première constante de temps étant plus grande que la deuxième constante de temps.

18. Appareil auditif selon une les revendications 10 à 17, **caractérisé en ce qu'**une valeur moyenne momentanée du niveau de signal d'entrée (s) est utilisable comme niveau de référence (sm; sm1; sm2).
